# EUROPÄISCHE PATENTSCHRIFT

(11) **EP 2 956 780 B1**
(45) Veröffentlichungstag und Bekanntmachung des Hinweises auf die Patenterteilung: **10.07.2019**
(21) Anmeldenummer: 14704582.7
(22) Anmeldetag: 14.02.2014
(51) Int. Cl.: H01R 13/03, H01R 13/11, G01R 11/04, H01R 9/24

(54) **ELEKTRIZITÄTSZÄHLER-ANSCHLUSSKLEMMENBLOCK UND ELEKTRIZITÄTSZÄHLER HIERZU**
ELECTRICITY METER CONNECTION TERMINAL BLOCK, AND ELECTRICITY METER
BLOC DE BORNES DE CONNEXION DE COMPTEUR ÉLECTRIQUE ET COMPTEUR ÉLECTRIQUE CORRESPONDANT

(30) Priorität: 15.02.2013 DE 102013101533
(43) Veröffentlichungstag der Anmeldung: 23.12.2015
(73) Patentinhaber: Wago Verwaltungsgesellschaft mbH, 32423 Minden (DE)
(72) Erfinder: GASSAUER, Stephan, 99768 Illfeld (DE)
(74) Vertreter: Gerstein, Hans Joachim
(86) Internationale Anmeldenummer: PCT/EP2014/052883
(87) Internationale Veröffentlichungsnummer: WO 2014/125060

(56) Entgegenhaltungen:
- DE-A1- 10 216 913
- DE-A1- 19 621 816
- DE-A1-102010 032 038
- US-A- 2 126 602
- US-A- 2 154 310
- US-A1- 2005 032 401
- Anonymous: "Reihenklemmen PTR Katalog", , 14. Februar 2013 (2013-02-14), Seiten 1-232, XP055118578, Internet Gefunden im Internet: URL:http://www.werner-electronic.de/de/wer ner-gmbh/produktsortiment/elektronische-ba uelemente/handelsvertretung.html?file=tl_f iles/WernerGmbH/Downloads/Datenblaetter/Da tenblaetter Handelsvertretungen/PTR-Katalog_Reihenklem men.pdf [gefunden am 2014-05-16]

## Beschreibung

Die Erfindung betrifft einen Elektrizitätszähler-Anschlussklemmenblock mit einem Isolierstoffgehäuse, mit Leiteranschlüssen zum Anschluss elektrischer Energieversorgungsleitungen und mit Elektrizitätszähler- Anschlussklemmen - zur elektrisch leitenden Verbindung von Leiteranschlüssen mit zugeordneten Anschlusskontakten eines von dem Elektrizitätszähler-Anschlussklemmenblock aufgenommenen Elektrizitätszählers.

Elektrizitätszähler werden insbesondere in Haushalten zur Messung der verbrauchten elektrischen Energie genutzt. Hierzu werden die Versorgungsleitungen durch ein Leistungsmessgerät hindurchgeschleift und die verbrauchte elektrische Energie gemessen.

Zum Anschließen eines Elektrizitätszählers müssen die Energieversorgungsleitungen, d. h. die Phasenleitungen L1 , L2, L3 und der Null-Leiter N (Rückleiter) sowie ggf. eine Schutzerde PE mit Leiteranschlussklemmen des Elektrizitätszählers verbunden werden. Der Austausch von Energiezählern gestaltet sich hierdurch sehr umständlich und darf nur durch Fachkräfte durchgeführt werden.

Eine Verbesserung wird durch Elektrizitätszähler- Anschlussklemmenblöcke erreicht, wie sie beispielsweise aus DE 2 256 373 A, DE 196 13 869 A1 und DE 41 13 328 A1 bekannt sind. Die Anschlussklemmenblöcke haben ein Isolierstoffgehäuse mit Befestigungselementen zur Wandmontage, Leiteranschlüsse zum Anschluss elektrischer Energieversorgungsleitungen und Elektrizitätszähler- Anschlussklemmen zur Aufnahme und Kontaktierung zugeordneter Anschlussklemmen eines Elektrizitätszählers. Die Anschlusskontakte der Elektrizitätszähler sind dabei als Stiftkontakte ausgeführt, die in Federbügelkontakte eintauchen. Die Federbügelkontakte haben zwei einander gegenüberliegende Federbügel und eine zwischenliegende, die Federbügel gegeneinander drückende Druckfeder.

DE 10 201 1 015 697 A1 offenbart einen Zählerschaltblock mit mindestens zwei Zählerschaltkontakten je Phase für einen Anschluss an den Elektrizitätszähler, der mindestens zwei Kontaktstücke je Phase hat. Der Zählerschaltblock umfasst ein Schaltelement, mit dem die Zählerschaltkontakte zwischen einer Betriebsposition und einer Entnahmeposition hin- und hergeschaltet werden können. Weiterhin ist eine Überbrückungsvorrichtung für einen solchen Zählerschaltkontakt vorgesehen. Die Elektrizitätszähler- Anschlussklemmen des Zählerschaltblocks sind aus zwei einander gegenüberliegenden, federbelasteten Zählerschaltkontakten gebildet. Beim Einführen der Überbrückungsvorrichtung werden die Elektrizitätszähler- Anschlussklemmen geöffnet, um das Entnehmen oder Anschließen eines Elektrizitätszählers unter Schonung der Elektrizitätszähler- Anschlussklemmen zu erleichtern.

DE 196 21 861 A1 zeigt einen Steckverbinder zum Aufstecken und Anklemmen eines Elektrizitätszählers. Der Elektrizitätszähler hat Schraub-Buchsenkontakte zur Aufnahme von Anschlussstiften, die von dem Steckverbinder abragen und im Steckverbinder ebenfalls mit Schraub-Buchsenkontakten verbunden sind.

In "Reihenklemmen PTR-Katalog", 14. Februar 2013, Seiten 1 bis 232, XP055118578 sind Reihenklemmen mit Flachsteckanschluss beschrieben, die zur Aufnahme eines Steckers mit einer sich daran anschließenden Leitung vorgesehen und geeignet sind. Diese auf eine Tragschiene aufrastbaren Reihenklemmen sind nicht zur Aufnahme eines darauf aufsteckbaren Gerätes eingerichtet.

Ausgehend hiervon ist es Aufgabe der vorliegenden Erfindung, einen verbesserten Elektrizitätszähler-Anschlussklemmenblock zu schaffen.

Die Aufgabe wird durch den Elektrizitätszähler-Anschlussklemmenblock mit den Merkmalen des Anspruchs 1 gelöst. Vorteilhafte Ausführungsformen sind in den Unteransprüchen beschrieben.

Es wird vorgeschlagen, dass die elektrische Kontaktierung zwischen dem Elektrizitätszähler-Anschlussklemmenblock und dem Elektrizitätszähler mit Hilfe korrespondierender Messer-Gabelkontakte durchgeführt wird. Hierzu sind die Elektrizitätszähler-Anschlussklemmen als Gabelkontakte mit zwei über eine gemeinsame Zungenwurzel verbundenen Gabelzinken zur Kontaktierung eines zugeordneten, zwischen den Gabelzinken aufnehmbaren Messerkontaktes eines Elektrizitätszählers ausgebildet.

Im Unterschied zu den bisherigen Zähleranschlüssen mit runden oder quadratischen Kontaktstiften und aufwändigem Federkontakt mit separater Druckfeder gelingt es mit Messer-Gabelkontakten unter Nutzung einfach zu fertigender und materialsparender Federklemmkontakte hohe Leistungen zu übertragen. Es wurde zudem erkannt, dass auch bei Messer- Gabelkontakten ein einfaches, mittels eines Überbrückungssteckers sogar kraftfreies Aufstecken und Entfernen eines zugeordneten Messerkontaktes möglich ist.

Die Gabelkontakte haben den Vorteil eines direkten und kurzen Stromweges von dem Anschlusskontakt für den Messerkontakt zu dem Leiteranschluss, der ebenfalls unter Nutzung des Materials des Gabelkontakts als Stromschiene vorzugsweise als Federkraftklemmanschluss realisiert werden kann.

Dabei sind in dem Isolierstoffgehäuse Anschlusskontakt-Aufnahmeöffnungen zur Aufnahme jeweils eines zugeordneten Anschlusskontaktes eines Elektrizitätszählers eingebracht. Diese Anschlusskontakt-Aufnahmeöffnungen definieren eine Einführrichtung der Anschlusskontakte in das Isolierstoffgehäuse des Elektrizitätszähler- Anschlussklemmenblocks. Die als Gabelkontakte ausgeführten Energiezähler-Anschlussklemmen erstrecken sich quer zur Einführrichtung von zugeordneten Messerkontakten, die in eine jeweilige Anschlusskontakt-Aufnahmeöffnung einführbar sind. Unter quer wird verstanden, dass die Messerkontakte durch eine von den Gabelkontakten
aufgespannte Ebene in den durch die Gabelkontakte gebildeten Kontaktschlitz zwischen die Gabelkontakte eingeführt und von diesen dann beidseits kontaktiert werden. Es kommt daher nicht darauf an, dass die Gabelkontakte genau senkrecht zur Einführrichtung der Anschlusskontakte ausgerichtet sind. Die Erstreckungsrichtung der Gabelkontakte zur Einführrichtung sollte vorzugsweise etwa 60° bis 120° betragen. Unter Umständen sind aber auch stärker geneigte Varianten sinnvoll, die dann immer noch den Vorteil querstehender Gabelkontakte ausnutzen.

Die Leiteranschlüsse sind vorzugsweise als Federkraftklemmanschlüsse ausgeführt. Hierzu ist es vorteilhaft, wenn das Stromschienenstück der Federkraftklemmanschlüsse beispielsweise eine Klemmfeder trägt oder mit einer U-förmig gebogenen, direkt steckbaren Klemmfeder zusammenwirkt. Aus dem freien Ende der Stromschiene sind dann vorzugsweise Gabelkontakte gebildet.

Durch das Ausformen der Gabelkontakte integral mit einer Stromschiene für einen zugeordneten Federkraftklemmanschluss gelingt somit eine materialsparende Ausgestaltung der Elektrizitätszähler-Anschlussklemmen und der Leiteranschlüsse unter Ausnutzung einer sehr guten Stromübertragungsfähigkeit. Dabei lässt sich insbesondere ein sehr niedriger Strom-übergangswiderstand sicherstellen, so dass bei den relativ großen übertragenen Leistungen eine übermäßige Erwärmung des Elektrizitätszähler-Anschlussklemmenblocks vermieden wird.

Besonders vorteilhaft ist es, wenn die Stromschiene im Bereich des Gabelkontaktes von einer Stromschienenebene entgegengesetzt zu der Erstreckungsrichtung der freien Enden der Gabelzinken weggebogen ist und über einen Umlenkabschnitt hinweg in den einen Aufnahmeschlitz für einen Messerkontakt bildenden Abschnitt der Gabelzinken übergeht. Hierdurch ist der Gabelkontakt im Querschnitt U-förmig gebogen und bildet einen gegenüber der Stromschienenebene nach unten versetzten Aufnahmeraum für einen zugeordneten Messerkontakt. Durch den Umlenkabschnitt und den von der Stromschienenebene weggebogenen Abschnitt wird der Gabelkontakt ohne Vergrößerung der Baugröße verlängert und es wird erreicht, dass die von dem Gabelkontakt aufgebrachte Klemmkraft und Elastizität wesentlich verbessert wird. Dabei wird der bei einem angeklemmten Messerkontakt ohnehin von dem Messerkontakt eingenommene Raum zur Verlängerung der Gabelkontakte genutzt.

Besonders vorteilhaft ist es, wenn sich an einen durch die voneinander beabstandete Gabelzinken gebildeten Kontaktschlitz, der zur Aufnahme eines Messerkontaktes vorgesehen ist, ein im Vergleich zu dem Kontaktschlitz schmalerer Federschlitz anschließt. Durch einen solchen schmaleren Federschlitz wird der Federarm verlängert und die Federeigenschaften des Gabelkontaktes werden ohne Erhöhung des erforderlichen Bauraums auf materialsparende und einfache Weise verbessert. Der Federschlitz kann in den Umlenkabschnitt hineinlaufen. Denkbar wäre auch, dass der Kontaktschlitz in den Umlenkabschnitt hineingeführt wird. Dadurch würde allerdings die Stromtragfähigkeit reduziert werden.

Besonders vorteilhaft ist es, wenn mindestens ein Verriegelungselement zur Verriegelung des Elektrizitätszähler-Anschlussklemmenblocks mit einem eingeführten Anschlusskontakt eines Elektrizitätszählers vorgesehen ist. Durch die Verriegelung des Elektrizitätszählers an dem Elektrizitätszähler-Anschlussklemmenblocks unter Verwendung der Anschlusskontakte des Elektrizitätszählers wird eine Verriegelung an einem sehr stabilen und massiven Material, nämlich den Anschlusskontakten erreicht. Es wird somit vorgeschlagen, die in der Regel aus stabilem Metallmaterial gebildeten Anschlusskontakte zur Verriegelung des Elektrizitätszählers an dem Elektrizitätszähler-Anschlussklemmenblock mit zu nutzen. Die Verriegelung eines Elektrizitätszählers an einem Elektrizitätszähler-Anschlussklemmenblock ist insofern wichtig und kritisch, da ein missbräuchlicher Austausch von Elektrizitätszählern sicher vermieden werden muss.

Hierzu ist es besonders vorteilhaft, wenn ein Elektrizitätszähler-Anschlussklemmenblock mit einem Isolierstoffgehäuse, mit Leiteranschlüssen zum Anschluss elektrischer Energieversorgungsleitungen und mit Elektrizitätszähler-Anschlussklemmen zur elektrisch leitenden Verbindung von Leiteranschlüssen mit zugeordneten Anschlusskontakten eines von dem Elektrizitätszähler-Anschlussklemmenblocks aufgenommenen Elektrizitätszählers mindestens ein Verriegelungselement benachbart zu einer zugeordneten Elektrizitätszähler-Anschlussklemme in dem Isolierstoffgehäuse hat. Das Verriegelungselement ist dabei federbelastet und von einer Offenposition unter Federkraft in eine Verriegelungsposition verlagerbar. In der Verriegelungsposition taucht das Verriegelungselement in eine Rastmulde eines eingeführten Anschlusskontaktes eines Energiezählers ein. Beim Austausch eines Elektrizitätszählers kann somit das federbelastete Verriegelungselement von der Verriegelungsposition in eine Offenposition verlagert werden, in der die Rastmulde eines eingeführten Anschlusskontaktes freigegeben wird. Damit wird eine Verriegelung des Anschlusskontaktes an der Rastmulde aufgehoben und der Energiezähler kann einfach entfernt werden.

Weiterhin ist es vorteilhaft, wenn das Isolierstoffgehäuse zu den freien Enden der Gabelzinken der Gabelkontakte hin geöffnete Brückeröffnungen zur Aufnahme von Brücker-Messerkontakten eines von dem Elektrizitätszähler-Anschlussklemmenblocks aufnehmbaren Überbrückungselementes hat. Mit Hilfe eines solchen Überbrückungselementes kann bei Austausch eines Energiezählers der weitere Betrieb der nachgeschalteten Energieversorgungsanlage sichergestellt werden. Der Elektrizitätszähler kann mit Hilfe eines Überbrückungselementes somit ohne Beeinträchtigung z. B. des versorgten Haushaltes ausgetauscht werden.

Mit Hilfe des Überbrückungselementes lässt sich zudem das mindestens eine Verriegelungselement entriegeln. Dieses Verriegelungselement ist vorzugsweise dann als federbelasteter Riegel zum Eintauchen in eine Rastmulde eines eingeführten Anschlusskontaktes eines Elektrizitätszählers ausgebildet.

Das Überbrückungselement weitet im gestecktem Zustand den Kontaktschlitz des Gabelkontaktes auf und ermöglicht damit ein kraftreduziertes oder kraftloses Einführen oder Entnehmen eines Messerkontaktes aus dem zugeordneten Kontaktschlitz.

Die Erfindung wird nachfolgend anhand von Ausführungsbeispielen mit den beifügten Zeichnungen näher erläutert. Es zeigen:
- Figur 1: - perspektivische Ansicht eines Elektrizitätszähler-Anschluss-klemmenblocks mit darauf aufgestecktem Elektrizitätszähler;
- Figur 2: - Blockschaltbild des Elektrizitätszähler-Anschluss-klemmenblocks mit daran angeklemmten Elektrizitätszähler;
- Figur 3: - Seiten-Schnittansicht durch den Elektrizitätszähler-Anschluss-klemmenblock mit darauf aufgestecktem Elektrizitätszähler aus Figur 1;
- Figur 4: - Seiten-Schnittansicht nach Figur 3 mit eingestecktem Überbrückungselement;
- Figur 5: - perspektivische Ansicht einer Elektrizitätszähler-Anschluss-klemmen als Gabelkontakt von der Vorderseite;
- Figur 6: - perspektivische Rückseitenansicht der Elektrizitätszähler-Anschlussklemme aus Figur 5;
- Figur 7: - Front-Schnittansicht des Gabelkontakts mit eingestecktem Messerkontakt eines Elektrizitätszählers;
- Figur 8: - perspektivische Ansicht eines Elektrizitätszähler-Anschluss-klemmenblocks mit aufgestecktem Elektrizitätszähler und Überbrückungselement;
- Figur 9: - perspektivische Schnittansicht durch den Elektrizitätszähler-Anschlussklemmenblock mit Elektrizitätszähler und Überbrückungselement aus Figur 8;
- Figur 10: - Front-Schnittansicht eines Gabelkontakts mit gestecktem Messerkontakt und Überbrückungselement in der Vorderansicht;
- Figur 11: - Front-Schnittansicht gemäß Figur 10 ohne Messerkontakt eines Elektrizitätszählers;
- Figur 12: - Teilschnittansicht auf einen Gabelkontakt mit daran angrenzendem federbelastetem Verriegelungselement in der Verriegelungsposition;
- Figur 13: - Teilschnittansicht gemäß Figur 12 mit gestecktem Überbrückungselement und Verriegelungselement in der Offenstellung;
- Figur 14: - Teilschnittansicht gemäß Figur 13 mit eingestecktem Messerkontakt in der Offenstellung;
- Figur 15: - Teilschnittansicht gemäß Figur 12 mit eingestecktem Messerkontakt in der Verriegelungsposition des Verriegelungselementes;
- Figur 16: - perspektivische Ansicht eines Gabelkontakt mit daran angrenzendem federbelastetem Verriegelungselement und eingestecktem Messerkontakt;
- Figur 17: - perspektivische Ansicht eines Gabelkontakts mit durch das Querbrückerelement in die Offenstellung verlagertem Verriegelungselement;
- Figur 18: - perspektivische Ansicht eines Verriegelungselementes;
- Figur 19: - Seitenschnittansicht durch einen Elektrizitätszähler-Anschlussklemmenblock mit gestecktem Überbrückungselement zur Verlagerung des Verriegelungselements in die Offenstellung;
- Figur 20: - perspektivische Ansicht eines Elektrizitätszählers mit einer ersten Ausführungsform von Messerkontakten mit Rastmulden an jedem Messerkontakt;
- Figur 21: - perspektivische Rückseitenansicht des Elektrizitätszählers aus Figur 20;
- Figur 22: - perspektivische Ansicht eines Elektrizitätszählers mit Messerkontakten und Rastmulden an den äußeren Messerkontakten;
- Figur 23: - perspektivische Rückseitenansicht des Elektrizitätszählers aus Figur 22;
- Figur 24: - perspektivische Ansicht eines Überbrückungselementes zur elektrischen Überbrückung von Elektrizitätszähler-Anschluss-klemmen und zur Betätigung eines Verriegelungselementes für den Elektrizitätszähler aus Figuren 22 und 23;
- Figur 25: - Teilschnittansicht des Anschlussbereichs der Elektrizitätszähler-Anschlussklemme mit aufgesetztem Elektrizitätszähler und Abdeckung.

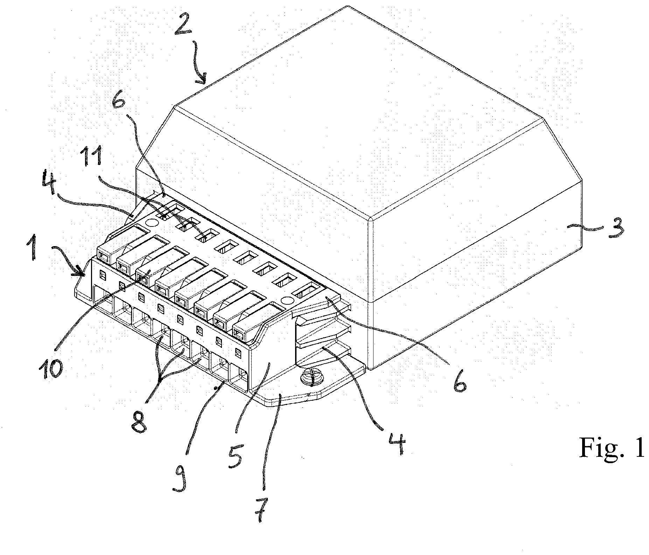

Figur 1 lässt eine perspektivische Ansicht eines Elektrizitätszähler-Anschlussklemmenblocks 1 mit darauf aufgestecktem Elektrizitätszähler 2 erkennen. Von dem Gehäuse 3 des Elektrizitätszählers 2 ragen beidseits voneinander beabstandete Führungslaschen 4 ab, die an Seitenwänden 5 des Elektrizitätszähler-Anschlussklemmenblocks 1 anliegen und durch Vorsprünge 6 und eine Bodenplatte 7 des Elektrizitätszähler-Anschlussklemmenblocks 1 eine vorgegebene Einsteckrichtung und Lage des Elektrizitätszählers 2 zum Elektrizitätszähler-Anschlussklemmenblock 1 sicherstellen. Dabei greifen nicht sichtbare Messerkontakte des Elektrizitätszählers 2 in nicht sichtbare Gabelkontakte des Elektrizitätszähler-Anschlussklemmenblocks 1 ein. Der Elektrizitätszähler-Anschlussklemmenblock 1 hat gegenüberliegend zum Elektrizitätszähler 2 Leitereinführungsöffnungen 8, die zu nicht sichtbaren Leiteranschlüssen zum Anschluss von in die Leitereinführungsöffnungen 8 eingeführten elektrischen Energieversorgungsleitungen führen. Die Leiteranschlüsse sind als Federklemmkontakte ausgeführt, die eine Klemmstelle für eine jeweils anzuschließende Energieversorgungsleitung bilden. Die Klemmstellen können mittels der von der Oberseite aus zugänglichen, schwenkbar im Isolierstoffgehäuse 9 des Elektrizitätszähler-Anschlussklemmenblocks 1 eingebauten Betätigungshebeln 10 geöffnet und geschlossen werden.

Weiterhin ist deutlich, dass Brückeröffnungen 11 an der Oberseite des Isolierstoffgehäuses 9 des Elektrizitätszähler-Anschlussklemmenblocks 1 benachbart zum Energiezähler 2 auf derselben Seite der Betätigungshebel 10 vorhanden sind. Diese Brückeröffnungen 11 dienen zur Aufnahme von Brückerkontakten eines Überbrückungselementes (nicht dargestellt). Damit ist während des Austauschs eines Elektrizitätszählers 2 eine Überbrückung der Leiteranschlüsse für die Energieversorgungsleitungen derart möglich, dass die weitere Versorgung mit elektrischer Energie auch bei ausgebautem Elektrizitätszähler 2 möglich bleibt.

In Betrieb sind die Brückeröffnungen 11 sowie der gesamte Anschlussbereich mit einer geeigneten Abdeckung abgedeckt. Die Abdeckung (nicht sichtbar) ist dabei vorzugsweise verplombt, um eine missbräuchliche Überbrückung eines eingebauten Energiezählers 2 und damit einen Stromdiebstahl zu verhindern.

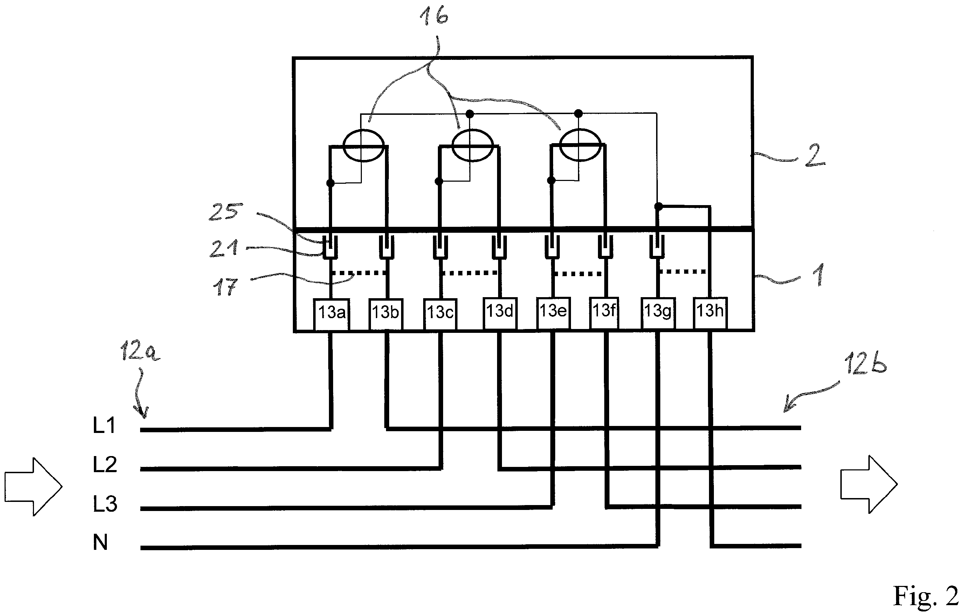

Figur 2 lässt ein elektrisches Blockdiagramm des Elektrizitätszähler-Anschlussklemmenblocks 1 mit aufgestecktem Elektrizitätszähler 2 erkennen. Deutlich wird, dass die Energieversorgungsleitungen 12 mit den drei Phasen L1, L2, L3 und dem Rückleiter N an die Leiteranschlüsse 13a, 13c, 13e, 13g geführt sind. Die z. B. zur Versorgung eines Gebäudes in dieses hineinführenden elektrischen Energieversorgungsleitungen 12b sind an die Leiteranschlüsse 13b, 13d, 13f und 13h angeklemmt. Die Leiteranschlüsse 13a bis 13h sind jeweils zu Elektrizitätszähler-Anschlussklemmen 21 geführt. Diese Elektrizitätszähler-Anschlussklemmen 21 sind zur elektrisch leitenden Steckverbindung eines Elektrizitätszählers 2 mit dem Elektrizitätszähler-Anschlussklemmenblock 1 vorgesehen. Sie sind wie skizziert als Gabelkontakte ausgeführt, an die jeweils ein Messerkontakt 25 als Anschlusskontakt eines Elektrizitätszählers 2 anklemmbar sind. Der Elektrizitätszähler 2 hat eine digitale oder analoge Messeinrichtung 16 zur Messung und Aufzeichnung des Verbrauchs an elektrischer Energie an den drei Phasen L1, L2 und L3 in Bezug auf den Rückleiter N. Der durch die Energieversorgungsleitungen 12a des Versorgers in die Energieversorgungsleitung 12b des Verbrauchers in den drei Phasen L1, L2 und L3 fließende Strom wird somit bezogen auf die Spannung aufsummiert, um dadurch die verbrauchte elektrische Energie zu erfassen.

Erkennbar ist weiterhin, dass die Leiteranschlüsse 13a bis 13h zum Anschluss elektrischer Energieversorgungsleitungen 12a, 12b mit Hilfe gestrichelt dargestellter Brücker 17 gebrückt werden können. Damit wird während des Austauschens eines Energiezählers 2 die weitere Energieversorgung sichergestellt.

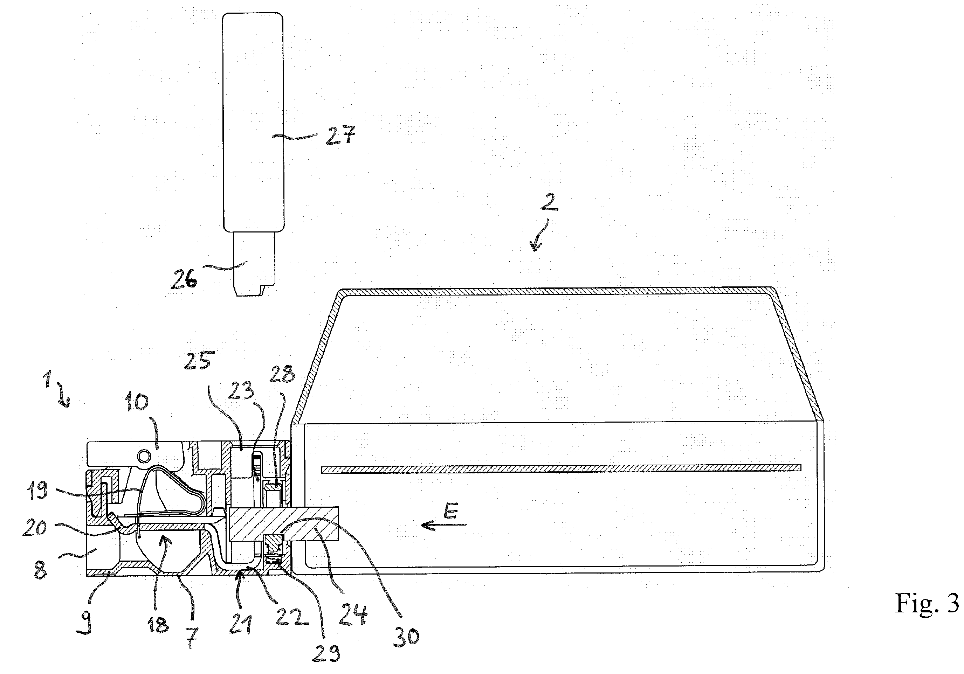

Figur 3 lässt eine Seitenschnittansicht des Elektrizitätszähler-Anschlussklemmenblocks 1 mit aufgestecktem Elektrizitätszähler 2 erkennen. Deutlich wird, dass die Leitereinführungsöffnungen 8 zum Einführen von elektrischen Energieversorgungsleitungen 12a, 12b zu einem zugeordneten Leiteranschluss 18 in Form eines Federkraftklemmanschlusses führen. Dieser ist z. B. aus einer schlaufenförmig gebogenen Klemmfeder 19 (z. B. Käfigzugfeder) und einem Stromschienstück 20 gebildet, um mit dem Klemmschenkel unter der Federkraft der Klemmfeder 19 einen elektrischen Leiter zwischen einem Quersteg am freien Ende des Klemmschenkels und dem Stromschienenstück 20 festzuklemmen. Für das Öffnen der Klemmfeder 19 ist ein Betätigungshebel 10 schwenkbar in dem Isolierstoffgehäuse 9 des Elektrizitätszähler-Anschlussklemmenblocks 1 aufgenommen.

Die Stromschiene 20 erstreckt sich in Richtung des aufgesteckten Elektrizitätszählers 2, wobei am freien Ende der Stromschiene 20 Elektrizitätszähler-Anschlussklemmen 21 ausgebildet sind. Hierzu ist die Stromschiene 20 zur Bodenplatte 7 des Isolierstoffgehäuses 9 hin umgefaltet und nach einem Umlenkabschnitt 22 in die der Bodenplatte 7 entgegengesetzten Richtung umgefaltet. An dem sich von der Bodenplatte 7 nach oben erstreckenden freien Endabschnitt der Stromschiene 20 sind Gabelzinken 23 eines Gabelkontaktes 21 ausgebildet. Zwei Gabelzinken 23 erstrecken sich parallel zueinander und sind durch einen Kontaktschlitz zur Aufnahme eines Messerkontakts 24 des Elektrizitätszählers 2 voneinander beabstandet. Erkennbar ist, dass die Gabelzinken 23 quer zur Einführungsrichtung eines zugeordneten Messerkontaktes 24 stehen. Dabei kommt es nicht auf die genaue rechtwinklige Anordnung zueinander an. Wesentlich ist, dass beim Einführen des Messerkontakts 24 in Einführrichtung E der Messerkontakt 24 nicht vom freien Ende der Gabelzinken 23 in den Kontaktschlitz eingeführt wird, sondern über eine durch die Gabelzinken 23 aufgespannte Ebene.

Der Messerkontakt 24 wird durch die U-förmige Biegung des Gabelkontaktes 21 in einem vom Gabelkontakt 21 aufgespannten Raum aufgenommen, wobei die Länge des Elektrizitätszähler-Anschlussklemmenblocks 1 in Erstreckungsrichtung trotz großer Erstreckungslänge der Gabelkontakte 21 nicht erhöht ist. Der Elektrizitätszähler-Anschlussklemmenblock 1 kann durch diese raumsparende Anordnung der Gabelkontakte 21 somit sehr kompakt ausgeführt sein.

Deutlich wird weiterhin, dass an der Oberseite des Isolierstoffgehäuses 9, die der Bodenplatte 7 gegenüberliegt, eine Brückeröffnung 25 zu dem zugeordneten Gabelkontakt 21 führt. Auf diese Weise kann dann ein Brücker-Messerkontakt 26 eines Überbrückungselementes 27 entgegengesetzt zur Erstreckungsrichtung der Gabelzinken 23 über das freie Ende der Gabelzinken 23 in den Kontaktschlitz eines Gabelkontakts 21 eingeführt werden.

Weiterhin wird deutlich, dass angrenzend an die Gabelzinken 23, in Einsteckrichtung E gesehen, vor den Gabelzinken 23 ein Verriegelungselement 28 im Isolierstoffgehäuse 9 in der Elektrizitätszähler-Anschlussklemmenblocks 1 aufgenommen ist. Dieses Verriegelungselement 28 ist durch eine Druckfeder 29 federbelastet, um in der dargestellten Rastposition in eine Rastmulde 30 des zugeordneten Messerkontaktes 24 einzutauchen. Auf diese Weise wird der Elektrizitätszähler 2 über die Rastmulden 30 des zugeordneten Messerkontaktes 24 mit Hilfe des Verriegelungselementes 28 an dem Isolierstoffgehäuse 9 des Elektrizitätszähler-Anschlussklemmenblocks 1 verrastet. Diese Art des Aufbaus des Verriegelungselementes 28 und der Verrastung ist sehr platzsparend und nutzt das massive Material der Messerkontakte 24 zur Verrastung aus. Für die Entriegelung werden die Brücker-Messerkontakte 26 des Überbrückungselementes 27 mit genutzt.

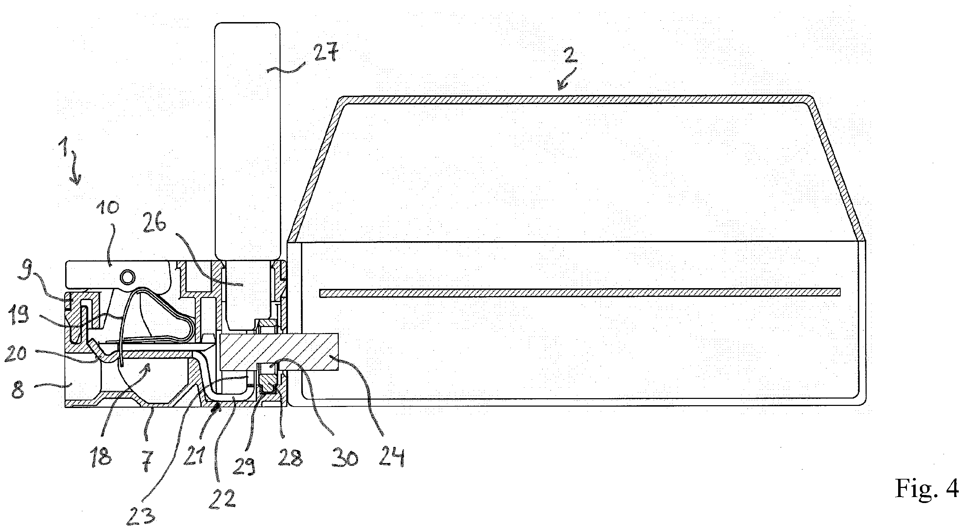

Dies ist aus der Figur 4 deutlich erkennbar, die den Elektrizitätszähler-Anschlussklemmenblock 1 mit aufgestecktem Elektrizitätszähler 2 in der Offenposition des Verriegelungselementes 28 zeigt. Hier ist das Verriegelungselement 28 entgegen der Kraft der zwischen dem Verriegelungselement 28 und der Bodenplatte 7 liegenden Druckfeder 29 in Richtung Bodenplatte 7 durch das freie Ende des zugeordneten Brücker-Messerkontaktes 26 des Überbrückungselementes 27 gedrückt. Damit wird die Rastmulde 30 freigeben und die Verriegelung des zugeordneten Messerkontaktes 24 aufgehoben.

Erkennbar ist weiterhin, dass der Brücker-Messerkontakt 26 in den Kontaktschlitz der Gabelzinken 23 des Gabelkontakts 21 eintaucht und somit elektrisch leitend mit dem zugeordneten Gabelkontakt 21 verbunden ist. Bei Abziehen des Elektrizitätszählers 2 kann damit immer noch eine elektrisch leitende Verbindung einer vom Energieversorger kommenden Energieversorgungsleitung 12a mit einer zum Verbraucher führenden zugeordneten Energieversorgungsleitung 12b durch Überbrücken der zugeordneten Leiteranschlüsse 18 sichergestellt werden.

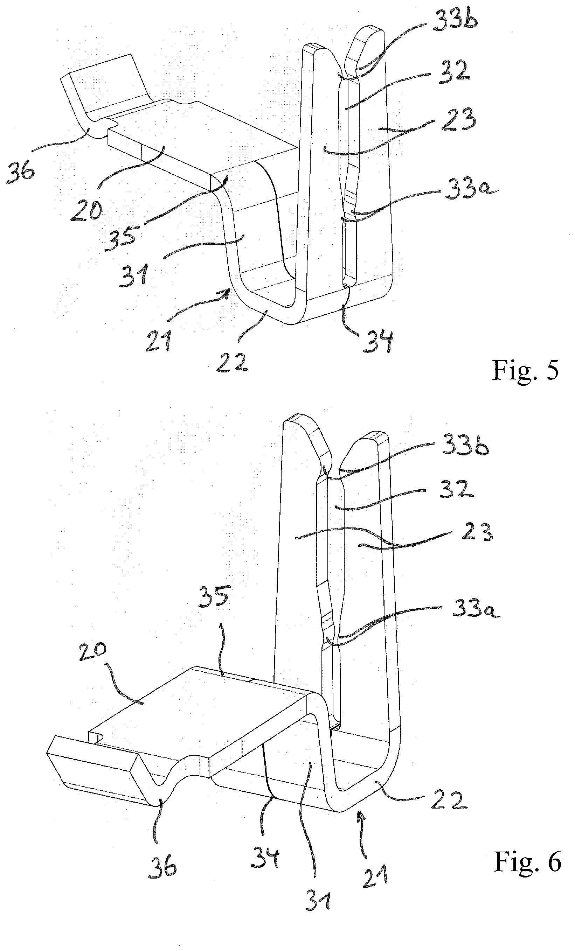

Figur 5 lässt eine perspektivische Frontseitenansicht der integral mit der Stromschiene 20 geformten Elektrizitätszähler-Anschlussklemme 21 in Form eines Gabelkontaktes erkennen. Deutlich wird, dass die Stromschiene 20 aus einer Stromschienenebene entgegengesetzt zur Erstreckungsrichtung der freien Enden der Gabelzinken 23 (nach unten) in einem ersten Abschnitt 31 heruntergebogen ist. Hieran schließt sich ein Umlenkabschnitt 22 an. Ausgehend von dem Umlenkabschnitt 22 sind die beiden sich parallel zueinander erstreckenden Gabelzinken 23 angeordnet, die sich quer zur Stromschienenebene 20 und entgegengesetzt zum ersten Abschnitt 31 nach oben erstrecken. Deutlich wird, dass ein Kontaktschlitz 32 zur Aufnahme eines zugeordneten Messerkontaktes 24 und eines Brücker-Messerkontaktes 26 zwischen den zwei voneinander beabstandten Gabelzinken 23 gebildet ist. Die Gabelzinken 23 haben einander gegenüberliegende Vorwölbungen 33a, 33b zur elektrischen Kontaktierung eines Messerkontakts 24 eines Elektrizitätszählers 2 bzw. eines Brücker-Messerkontakts 26 eines Überbrückungselementes 27. Mit Hilfe dieser Vorwölbung 33a, 33b wird die Kontaktkraft der als Federkraftanschluss wirkenden Gabelkontakte 21 auf einen möglichst kleinen Kontaktpunkt reduziert, um so die Flächenpressung zu erhöhen.

Der sich an die Gabelzinken 23 anschließende Abschnitt ist durch einen Federschlitz 34 voneinander zweigeteilt. Dieser Federschlitz 34 hat eine wesentlich kleinere Schlitzbreite als der Kontaktschlitz 32. Mit Hilfe dieses Federschlitzes 34 wird erreicht, dass die sich an die Gabelzinken 23 anschließende Zungenwurzel 35 eine größere Federkraft zwischen den Gabelzinken 23 bzw. den einander gegenüberliegenden Vorwölbungen 33a, 33b bewirkt.

Das den Gabelzinken 23 gegenüberliegende freie Ende der Stromschiene 20 hat ebenfalls eine Vorwölbung 36 aus der Ebene der Stromschiene 20 heraus, um so eine definierte, möglichst geringe Anlagefläche für einen Leiter zu schaffen, so dass die Klemmkraft der Klemmfeder 19 auf die Anlagefläche konzentriert wird.

Figur 6 lässt eine perspektivische Rückseitenansicht der Stromschiene 20 mit daran angeformtem Gabelkontakt 21 erkennen. Deutlich wird, dass das an die Vorwölbung 36 angrenzende freie Ende der Stromschiene 20 nach oben abgebogen ist, um so eine Einlaufschräge zum Einführen eines elektrischen Leiters unter die Unterseite der Stromschiene 20 zu bilden. Erkennbar ist weiterhin, dass die voneinander beabstandeten Gabelzinken 23 etwa in Höhe der Stromschienenebene 20 einander gegenüberliegende Vorwölbungen 33a zur Kontaktierung eines Messerkontaktes 24 eines Elektrizitätszählers 2 und benachbart zum freien Ende einander gegenüberliegende Vorwölbungen 33b zur elektrisch leitenden Kontaktierung eines Brücker-Messerkontaktes 26 haben.

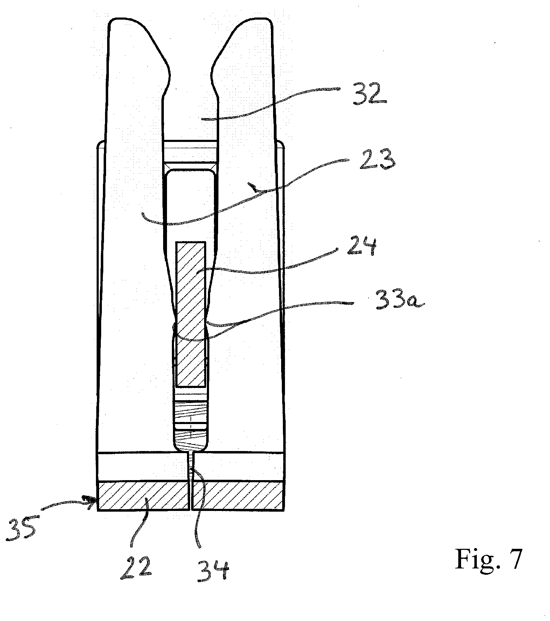

Figur 7 lässt eine Front-Schnittansicht auf den Gabelkontakt 21 aus Figuren 5 und 6 mit eingestecktem Messerkontakt 24 im Schnitt des Umlenkabschnitts 22 erkennen. Hierbei wird deutlich, dass der Messerkontakt 24 quer zu den Gabelzinken 23 steht und über die durch die Gabelzinken 23 aufgespannte Fläche in den Kontaktschlitz 23 eingeführt ist. Erkennbar ist dabei, dass der sich an den Kontaktschlitz 32 anschließende Federschlitz 34 durch den eingeschobenen Messerkontakt 24 leicht aufgebogen ist. Dies führt dazu, dass eine Federkraft auf die Gabelzinken 23 von der sich an die Gabelzinken 23 anschließenden Zungenwurzel 35 ausgeübt wird. Hierdurch liegen die Vorwölbungen 33a durch Federkraft an den einander gegenüberliegenden Kontaktflächen des Messerkontakts 24 an.

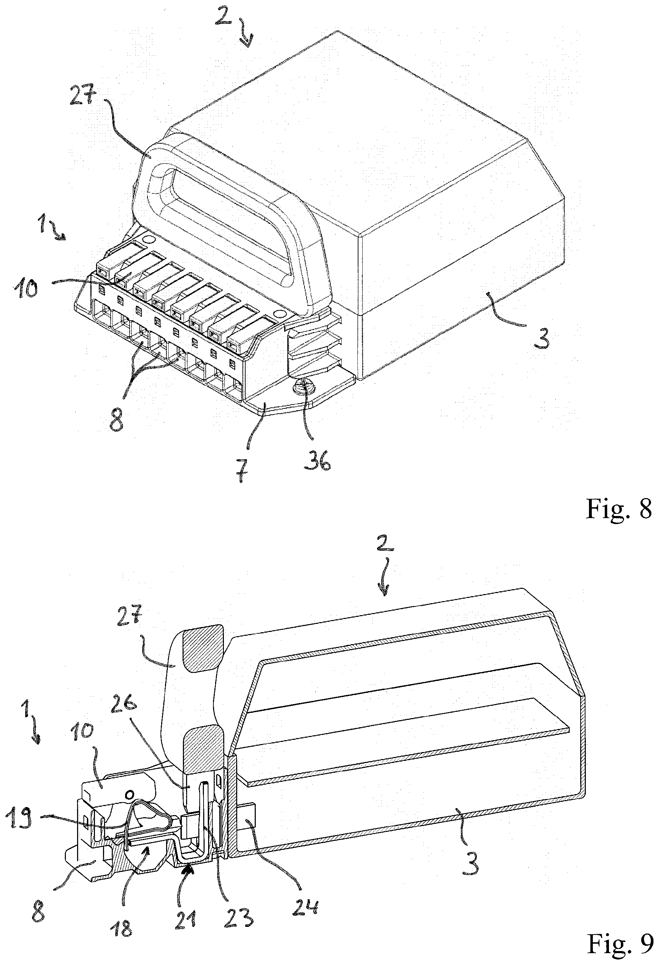

Figur 8 lässt eine perspektivische Darstellung eines Elektrizitätszähler-Anschlussklemmenblocks 1 mit aufgestecktem Elektrizitätszähler 2 sowie mit eingestecktem Überbrückungselement 27 erkennen. Deutlich wird, dass das Überbrückungselement 27 von oben in die Brückeröffnungen 11 eingesteckt ist. Im Übrigen kann auf die obigen Ausführungen verwiesen werden.

Ergänzend sei noch darauf hingewiesen, dass die Bodenplatte 7 mittels Befestigungselementen, wie Schrauben 36 z. B. an einer Wand oder einem anderen Träger montiert werden kann. Auch das Gehäuse 3 des Elektrizitätszählers 2 kann mindestens eine Befestigungseinrichtung zur Montage des Gehäuses 3 auf dem Träger nach Aufstecken auf den Elektrizitätszähler-Anschlussklemmenblock 1 haben.

Figur 9 lässt eine perspektivische Schnittansicht der Darstellung aus Figur 8 erkennen. Dabei wird deutlich, dass die Brücker-Messerkontakte 26 des Überbrückungselementes 27 beim Einstecken eines Überbrückungselementes 27 in den Elektrizitätszähler-Anschlussklemmenblock 1 in dem Kontaktschlitz zwischen den Gabelzinken 23 des Gabelkontaktes 21 aufgenommen sind. Damit wird der zugeordnete Leiteranschluss durch eine elektrisch leitende Querverbindung des Brücker-Messerkontaktes 26 mit einem weiteren parallel hierzu angeordneten Brücker-Messerkontaktes überbrückt.

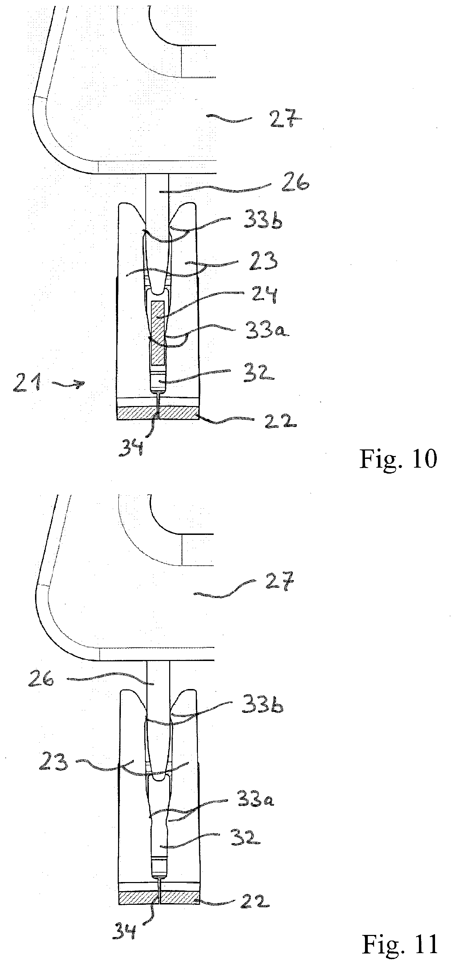

Figur 10 lässt die Situation aus Figur 9 als Front-Schnittansicht auf einen Gabelkontakt 21 mit eingestecktem Überbrückungselement 27 erkennen. Deutlich wird hierbei, dass der Brücker-Messerkontakt 26 eine größere Breite als der Messerkontakt 24 des Elektrizitätszählers 2 hat. Beim Aufstecken eines Überbrückungselementes 27 und Einführen des Brücker-Messerkontaktes 26 in den Kontaktschlitz 32 wird der Kontaktschlitz 32 stärker als für den Fall eines lediglich eingesteckten Messerkontaktes 24 aufgeweitet. Dadurch wird die Kontaktkraft der Gabelzinken 23 auf den Messerkontakt 24 reduziert und unter Umständen vollständig aufgehoben, so dass der Messerkontakt 24 nahezu kraftfrei oder zumindest mit reduzierter Kraft aus dem Gabelkontakt 21 entnommen bzw. beim Einstecken in den Gabelkontakt 21 eingeführt werden kann.

Figur 11 lässt die Situation gemäß Figur 10 nochmals ohne eingesteckten Messerkontakt erkennen. Der Kontaktschlitz unterhalb des freien Ende des Brücker-Messerkontakts 26 ist durch den eingesteckten Brücker-Messerkontakts 26 nunmehr so weit aufgeweitet, dass ein kraftarmes oder kraftfreies Einstecken eines Messerkontaktes 24 möglich wird.

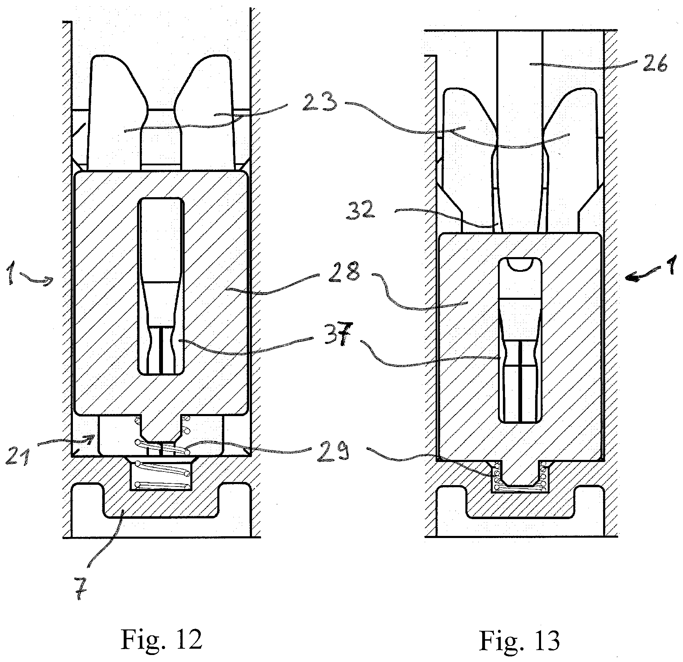

Figur 12 lässt eine Teilschnittansicht in Blickrichtung der Einführrichtung E eines Messerkontaktes 24 erkennen. Deutlich wird, dass in Blickrichtung, d. h. in Einführrichtung E quer zur Einführrichtung E ein Verriegelungselement 28 federbelastet durch eine Druckfeder 29 verschiebbar angeordnet ist. Das Verriegelungselement 28 hat eine zentrale rechteckige Aufnahmeöffnung 37 zum Aufnehmen und Hindurchführen eines Messerkontaktes 24 eines Elektrizitätszählers 2. In Einführrichtung E gesehen hinter dem Verriegelungselement 28, sind die Gabelzinken 23 des Gabelkontaktes 21 angeordnet. Deutlich wird, dass diese sich quer zur Einführrichtung E erstrecken. In der dargestellten Verriegelungsposition ist das Verriegelungselement 28 durch die Kraft der Druckfeder 29 von der Bodenplatte 7 in Richtung freien Enden der Gabelzinken 23 verlagert.

Figur 13 lässt eine Teilschnittansicht gemäß Figur 12 mit dem Verriegelungselement 28 nunmehr in der Offenstellung erkennen. Die Offenstellung wird dadurch erreicht, dass ein Betätigungsabsatz am freien Ende des Brücker-Messerkontakts 26 von oben auf die Oberkante des Verriegelungselementes 28 aufstößt und dieses beim Einführen des Brücker-Messerkontaktes 26 in den Kontaktschlitz 32 des Gabelkontaktes 21 nach unten entgegen der Kraft der Druckfeder 29 verlagert.

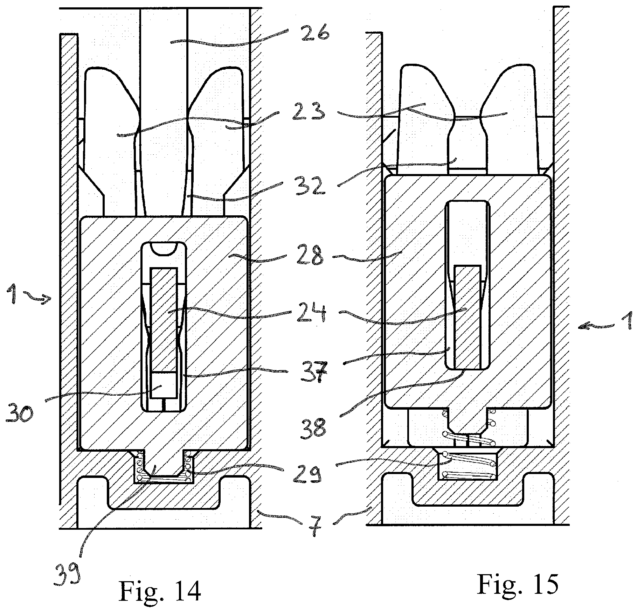

Figur 14 lässt eine Teil-Schnittansicht gemäß Figur 13 mit nunmehr eingeführtem Messerkontakt 24 eines Elektrizitätszählers 2 erkennen. Deutlich wird, dass die Aufnahmeöffnung 37 des Verriegelungselementes 28 ausreichend breit und lang im Vergleich zu dem Querschnitt des Messerkontaktes 24 ist, um ein berührungsfreies Durchführen des Messerkontaktes 24 durch das Verriegelungselement 28 zu ermöglichen.

Aus Figur 15 wird deutlich, dass das Verriegelungselement 28 nach Abziehen des Überbrückungselementes und des zugeordneten Brücker-Messerkontaktes 26 aus dem Kontaktschlitz 32 nunmehr durch die Kraft der Druckfeder 29 von der Bodenplatte 7 in Richtung freies Ende der Gabelzinken 23 verlagert ist. Dabei greift die untere Randkante 38 der Aufnahmeöffnung 37 des Verriegelungselementes 28 in die Rastmulde 30 des Messerkontaktes 24 ein und verhindert somit ein Abziehen des hierdurch elektrisch leitend angeklemmten Elektrizitätszählers 2 von dem Elektrizitätszähler-Anschlussklemmenblock 1.

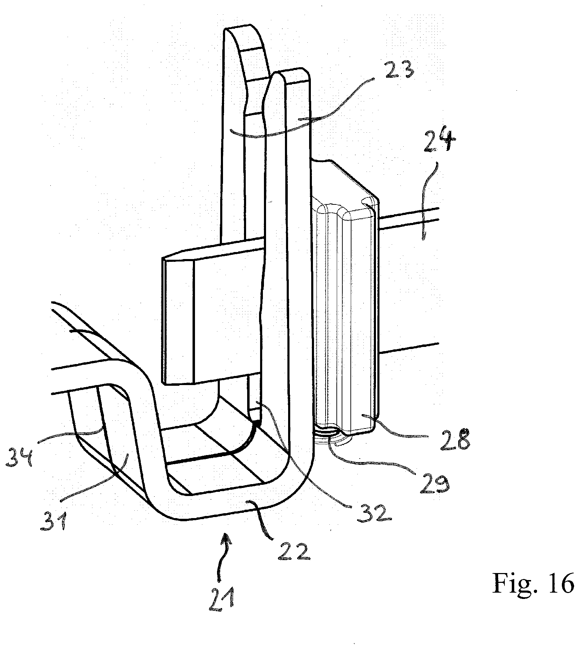

Figur 16 lässt eine perspektivische Ansicht des Gabelkontaktes 21 mit dem Verriegelungselement 28 und eingestecktem Messerkontakt 24 in der Verriegelungsposition gemäß Figur 15 erkennen. Deutlich wird hierbei, dass das Verriegelungselement 28 den Messerkontakt 24 allseitig umschließt und, wie aus Figur 15 erkennbar, an der Unterkante des Messerkontaktes 24 durch die Rastmulde 30 des Messerkontaktes 24 verrastet.

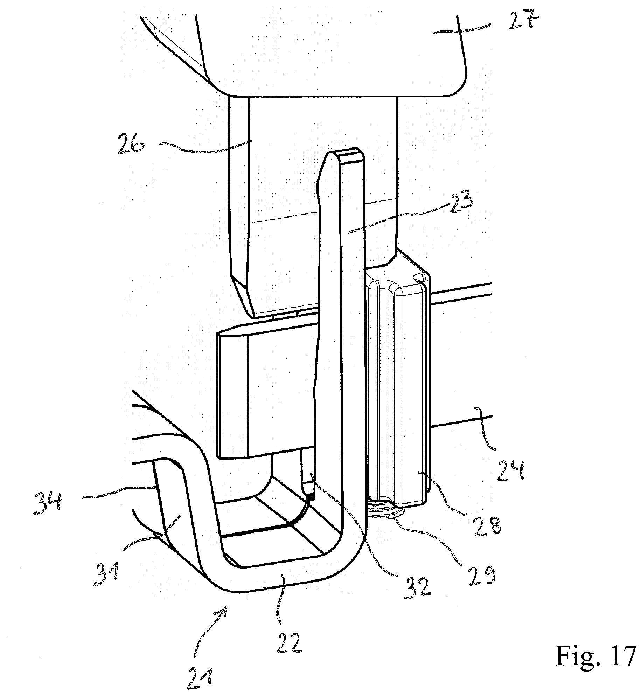

Figur 17 lässt eine perspektivische Ansicht gemäß Figur 16 bei eingestecktem Überbrückungselement 27 mit in den Klemmschlitz 32 eingeführtem Brücker-Messerkontakt 26 erkennen. Dabei wird das Verriegelungselement 24 durch den Brücker-Messerkontakt 26 nach unten entgegengesetzt zum freien Ende der Gabelzinken 23 gerichteten Erstreckungsrichtung der Gabelzinken verlagert.

Damit wird die Verrastung der Messerkontakte 24 aufgehoben.

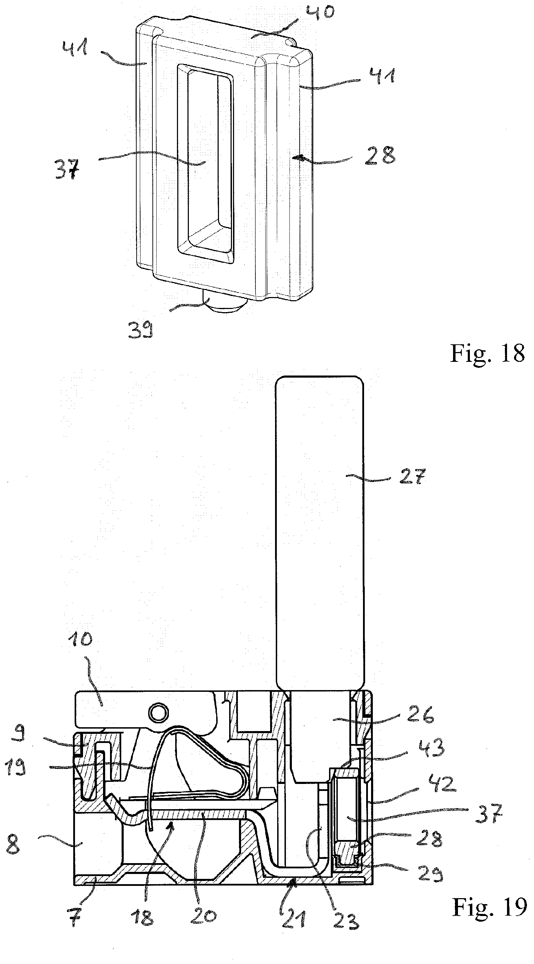

Figur 18 lässt eine perspektivische Ansicht des Verriegelungselementes 28 erkennen. Deutlich wird, dass das Verriegelungselement 28 z. B. ein als integral gefertigtes Kunststoffteil mit einer zentralen rechteckförmigen Aufnahmeöffnung 37 ist. An der Unterseite des Verriegelungselementes 28 ist ein Zapfen 39 zur Aufnahme der Druckfeder 29 vorgesehen. Das Verriegelungselement hat gegenüber dem Hauptkörper 40 schmalere Seitenkanten 41. Diese sind vorgesehen, um in Führungsnuten des Isolierstoffgehäuses 9 des Elektrizitätszähler-Anschlussklemmenblocks 1 aufgenommen zu werden. Auf diese Weise wird erreicht, dass das Verriegelungselement 28 linear beweglich und durch die Kraft der Druckfeder 29 federbeaufschlagt gelagert ist.

Figur 19 lässt eine Seiten-Schnittansicht des Elektrizitätszähler-Anschlussklemmenblocks 1 mit eingestecktem Überbrückungselement 27 nunmehr ohne Energiezähler 2 erkennen. Hierbei wird deutlich, dass eine Anschlusskontakt-Aufnahmeöffnung 42 gegenüberliegend zu den Leitereinführungsöffnungen 8 eingebracht ist, die durch die Aufnahmeöffnung 37 des Verriegelungselementes 28 zu der Elektrizitätszähler-Anschlussklemme in Form des Gabelkontaktes 21 führt. Erkennbar ist weiterhin, dass an dem Brücker-Messerkontakt 26 ein Betätigungsabsatz 43 am freien Ende vorhanden ist, in den die Oberkante des Verriegelungselementes 28 eintaucht und durch den das Verriegelungselement 28 in Richtung Bodenplatte 7 in die Offenposition verlagert wird.

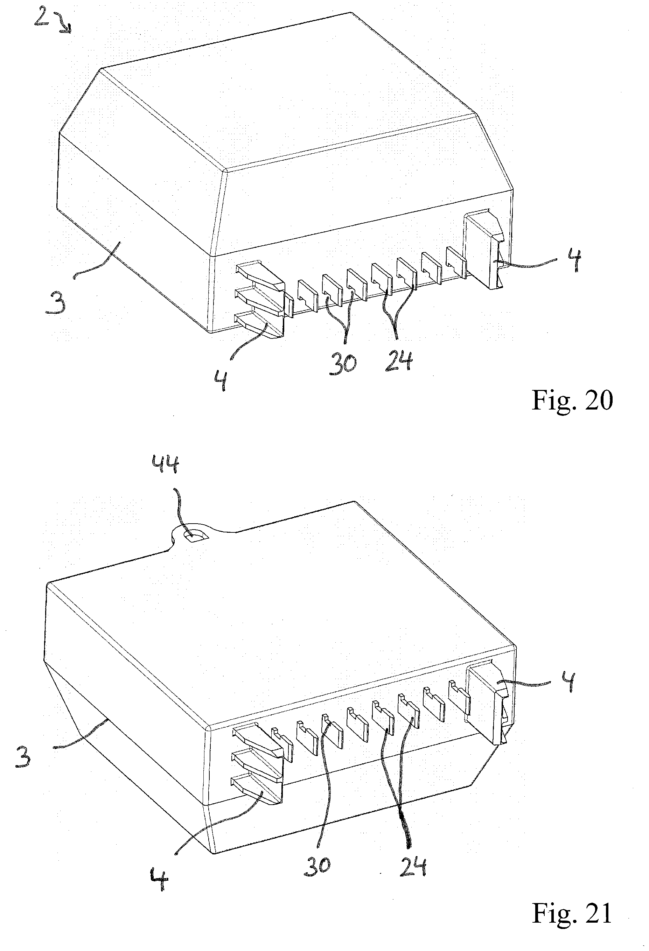

Figur 20 lässt eine perspektivische Ansicht einer ersten Ausführungsform eines Elektrizitätszählers 2 mit mehreren nebeneinander angeordneten und sich parallel zueinander erstreckenden Messerkontakten 24 an einer Stirnseite erkennen. Deutlich wird, dass alle diese Messerkontakte 24 an der Unterseite Rastmulden 30 haben. Erkennbar ist weiterhin, dass die Führungsstege 4 sich parallel zu den Messerkontakten 24 an derselben Stirnseite zur Ankopplung an einen Elektrizitätszähler-Anschlussklemmenblocks 1 in Abstand zueinander erstrecken. Die Führungslaschen 4 haben eine größere Länge und Breite als die Messerkontakte 24 und dienen damit auch zum Schutz der Messerkontakte 24 vor Verbiegen oder Abbrechen.

Figur 21 lässt den Elektrizitätszähler 2 aus Figur 20 in der perspektivischen Rückseitenansicht erkennen. Dabei wird deutlich, dass auf der Stirnseite, die der die Messerkontakte 24 aufweisenden Stirnseite gegenüberliegt, eine Befestigungsöse 44 vorhanden ist, mit welcher das Gehäuse 3 des Elektrizitätszählers 2 auf einem Träger verschraubt werden kann.

Der Elektrizitätszähler 2 lässt sich auf einem Träger mit nur einer Verschraubung an der Befestigungsöse 44 fest montieren, da die Verschraubung des Elektrizitätszähler-Anschlussklemmenblocks 1 aufgrund der Anbindung mit den Führungslaschen 4 mit zur Befestigung des Elektrizitätszählers 2 genutzt werden kann, ohne dass unzulässige Kräfte und Momente zwischen Elektrizitätszähler 2 und Elektrizitätszähler-Anschlussklemmenblock 1 wirken.

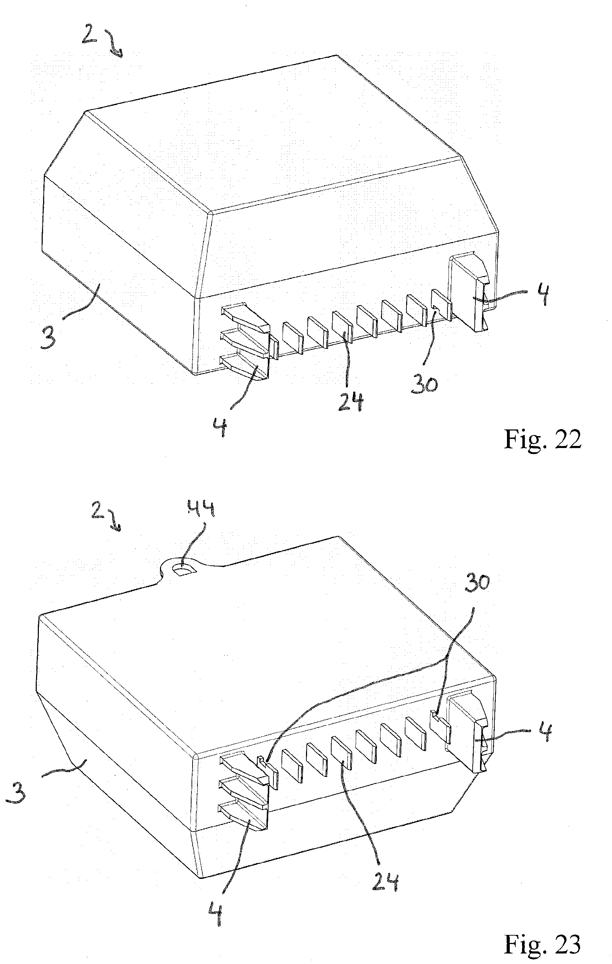

Figur 22 lässt eine perspektivische Ansicht einer zweiten Ausführungsform eines Elektrizitätszählers 2 in der perspektivischen Draufsicht erkennen. Im Unterschied zur Ausführungsform gemäß Figur 20 und 21 sind hierbei nicht alle Messerkontakte mit Rastmulden 30 versehen. Vielmehr sind nur an den äußeren beiden Messerkontakten 24 Rastmulden vorgesehen. Entsprechend sind in dem Elektrizitätszähler-Anschlussklemmenblock 1 auch nur für diese Messerkontakte 24 mit Rastmulden 30 Verriegelungselemente vorgesehen.

Die Bereitstellung von nur zwei Rastmulden 30 ist auch aus der perspektivischen Rückseitenansicht der Figur 23 deutlich erkennbar. Im Übrigen kann auf die Beschreibung zu den Figuren 20 und 21 verwiesen werden. Diese Anordnung führt zu einem geringeren Aufwand bei der Fertigung und Montage des Elektrizitätszähler-Anschlussklemmenblocks 1 und verringert die erforderliche Einsteckkraft für das Überbrückungselement 27.

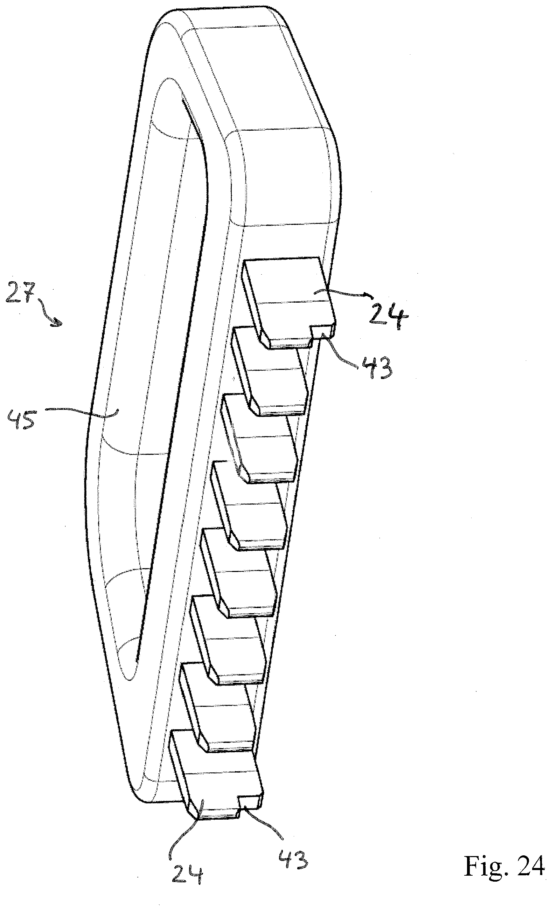

Figur 24 lässt eine perspektivische Ansicht eines Überbrückungselementes 27 erkennen. Das Überbrückungselement 27 hat einen Handgriffkörper 45 aus Isolierstoffmaterial, in dem elektrisch leitende Brücker (nicht sichtbar) zwischen einander zugeordneten Brücker-Messerkontakten 26 aufgenommen sind. Vorteilhaft sind jeweils zwei benachbarte Brücker-Messerkontakte 26 elektrisch leitend miteinander verbunden.

Deutlich wird, dass die äußeren beiden Brücker-Messerkontakte 26 breiter als die dazwischen liegenden Brücker-Messerkontakte 26 ausgebildet sind. Auf diese Weise werden die Betätigungsabsätze 43 zur Betätigung eines Verriegelungselements 28 geschaffen. Zudem wird hierdurch eine Codierung gegen ein Fehlstecken realisiert.

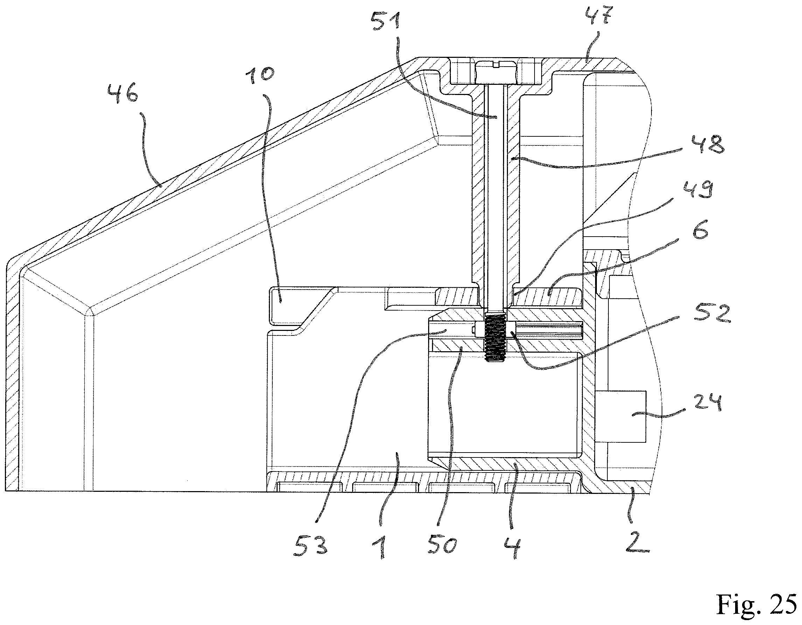

Figur 25 zeigt eine Teilschnittansicht des Anschlussbereichs der Elektrizitätszähler-Anschlussklemme 1 mit aufgesetztem Elektrizitätszähler 2 und einer Abdeckung 46. Die Abdeckung 46 überdeckt die Elektrizitätszähler-Anschlussklemme 1 vollständig und überragt mit einer Abdeckwandung 47 die Oberseite des Elektrizitätszählers 2 mindestens teilweise. Erkennbar ist, dass die seitliche Führungslasche 4 des Elektrizitätszählers 2 unter den Vorsprung 6 der Elektrizitätszähler-Anschlussklemme 1 geführt ist. An der Abdeckwandung 47 der Abdeckung 46 ist ein Dom 48 vorhanden, der von der Abdeckwandung bis zu dem Vorsprung 6 geführt ist, wenn die Abdeckung bestimmungsgemäß auf die Elektrizitätszähler-Anschlussklemme 1 mit aufgestecktem Elektrizitätszähler 2 aufgesetzt ist. In dem Vorsprung ist eine Öffnung 49 vorhanden, in die der Dom 48 eintaucht, um auf einer oberen Rippe 50 der Führungslasche 4 aufzusitzen. Der Dom 48 ist erkennbar als Hohlzylinder ausgestalten und zur Aufnahme einer Befestigungsschraube 51 vorgesehen. Die Befestigungsschraube 51 wird mit einem Gewindeblech 52 verschraubt, das in einen in der oberen Rippe 50 gebildeten Hohlraum 53 eingebaut ist. Alternative andere Ausgestaltungen zur Ausbildung einer Gewindemutter an der Führungslasche 4 sind denkbar.

Durch das Abstützen des Doms 48 auf der Führungslasche 4 wird erreicht, dass die Abdeckung 46 durch die Befestigung keine Kräfte oder Momente auf den Anschlussbereich zwischen Elektrizitätszähler 2 und Elektrizitätszähler-Anschlussklemme 1 ausübt, sondern direkt und ausschließlich mit dem Elektrizitätszähler 2 verbunden ist. Durch die Durchführung des Doms 48 durch die Öffnung 49 im Vorsprung 6 der Elektrizitätszähler-Anschlussklemme 1 wird zusätzlich sichergestellt, dass die Elektrizitätszähler-Anschlussklemme 1 und der Elektrizitätszähler 2 korrekt zueinander positioniert sind.

In dem dargestellten Ausführungsbeispiel ist der Durchmesser des freien Endes des Doms 48 gegenüber dem übrigen Abschnitt verjüngt. Die Länge des verjüngten freien Endes ist allerdings länger als die Dicke des Vorsprungs 6, so dass sichergestellt ist, dass der Dom nicht auf dem Vorsprung 6 aufliegt.

## Patentansprüche

1. Elektrizitätszähler-Anschlussklemmenblock (1) mit einem Isolierstoffgehäuse (9), mit Leiteranschlüssen (18) zum Anschluss elektrischer Energieversorgungsleitungen (12a, 12b) und mit Elektrizitätszähler-Anschlussklemmen (21) zur elektrisch leitenden Verbindung von Leiteranschlüssen (18) mit zugeordneten Anschlusskontakten (24) eines von dem Elektrizitätszähler-Anschlussklemmenblock (1) aufgenommenen Elektrizitätszählers (2), **dadurch gekennzeichnet, dass** die Elektrizitätszähler-Anschlussklemmen (21) als Gabelkontakte mit zwei über eine gemeinsame Zungenwurzel (35) miteinander verbundenen Gabelzinken (23) geeignet für eine Kontaktierung eines zugeordneten, zwischen den Gabelzinken (23) aufnehmbaren Messerkontaktes (24) eines Elektrizitätszählers (2) ausgebildet sind und dass das Isolierstoffgehäuse (9) Anschlusskontakt-Aufnahmeöffnungen (42) zur Aufnahme jeweils eines zugeordneten Anschlusskontaktes (24) eines Elektrizitätszählers (2) hat, wobei die Anschlusskontakt-Aufnahmeöffnungen (42) eine Einführrichtung (E) der Anschlusskontakte (24) in das Isolierstoffgehäuse (9) des Elektrizitätszähler-Anschlussklemmenblocks (1) definieren und dass sich die als Gabelkontakte ausgeführten Energiezähler-Anschlussklemmen (21) quer zur Einführrichtung (E) von zugeordneten Messerkontakten (24), die in eine jeweilige Anschlusskontakt-Aufnahmeöffnung (42) einführbar sind, erstrecken.

2. Elektrizitätszähler-Anschlussklemmenblock (1) nach Anspruch 1, **dadurch gekennzeichnet, dass** die Gabelkontakte (21) integral mit einer Stromschiene (20) für einen zugeordneten Leiteranschluss (18) geformt sind.

3. Elektrizitätszähler-Anschlussklemmenblock (1) nach Anspruch 2, **dadurch gekennzeichnet, dass** die Stromschiene (20) im Bereich des Gabelkontaktes (21) von einer Stromschienenebene entgegengesetzt zu der Erstreckungsrichtung der freien Enden der Gabelzinken (23) weggebogen ist und über einen Umlenkabschnitt (22) in den einen Kontaktschlitz (32) für einen Messerkontakt (24) bildenden Abschnitt der Gabelzinken (23) übergeht.

4. Elektrizitätszähler-Anschlussklemmenblock (1) nach einem der Ansprüche 1 bis 3, **dadurch gekennzeichnet, dass** die Leiteranschlüsse (18) als Federkraftklemmanschlüsse ausgeführt sind.

5. Elektrizitätszähler-Anschlussklemmenblock (1) nach einem der vorhergehenden Ansprüche, **dadurch gekennzeichnet, dass** sich an einen durch die voneinander beabstandeten Gabelzinken (23) gebildeten Kontaktschlitz (32) zur Aufnahme eines Messerkontaktes (24) ein im Vergleich zu dem Kontaktschlitz (32) schmalerer Federschlitz (34) anschließt.

6. Elektrizitätszähler-Anschlussklemmenblock (1) nach einem der vorhergehenden Ansprüche, **dadurch gekennzeichnet, dass** mindestens ein Verriegelungselement (28) zur Verriegelung des Elektrizitätszähler-Anschlussklemmenblocks (1) mit einem eingeführten Anschlusskontakt (24) eines Elektrizitätszählers (2) vorgesehen ist.

7. Elektrizitätszähler-Anschlussklemmenblock (1) nach einem der vorhergehenden Ansprüche, **dadurch gekennzeichnet, dass** das Isolierstoffgehäuse (9) zu den freien Enden der Gabelzinken (23) der Gabelkontakte (21) hin geöffnete Brückeröffnungen (11) zur Aufnahme von Brücker-Messerkontakten (26) eines von dem Elektrizitätszähler-Anschlussklemmenblock (1) aufnehmbaren Überbrückungselementes (27) hat.

8. Elektrizitätszähler-Anschlussklemmenblock (1) nach einem der Ansprüche 6 oder 7, **dadurch gekennzeichnet, dass** das Verriegelungselement (28) ein federbelasteter Riegel zum Eintauchen in eine Rastmulde (30) eines eingeführten Anschlusskontaktes (24) eines Elektrizitätszählers (2) ist.

9. Elektrizitätszähler-Anschlussklemmenblock (1) nach einem der vorhergehenden Ansprüche, **dadurch gekennzeichnet, dass** mindestens ein Verriegelungselement (28) benachbart zu einer zugeordneten Elektrizitätszähler-Anschlussklemme (21) in dem Isolierstoffgehäuse (9) angeordnet ist, wobei das Verriegelungselement (28) federbelastet und von einer Offenposition unter Federkraft in eine Verriegelungsposition verlagerbar und in der Verriegelungsposition zum Eintauchen in eine Rastmulde (30) eines eingeführten Anschlusskontaktes (24) eines Energiezählers (2) vorgesehen ist.

10. Elektrizitätszähler (2) mit einem Elektrizitätszähler-Anschlussklemmenblock (1) nach einem der vorhergehenden Ansprüche, **dadurch gekennzeichnet, dass** der Elektrizitätszähler (2) Messerkontakte (24) mit einem flachen Kontaktmesser zur Kontaktierung eines zugeordneten Gabelkontaktes (21) des Elektrizitätszähler-Anschlussklemmenblocks (1) hat, wobei mindestens einer der Messerkontakte (24) eine Rastmulde (30) hat, die zur Verrastung mit einem Verriegelungselement (28) eines Elektrizitätszähler-Anschlussklemmenblocks (1) ausgebildet ist.

## Claims

1. Electricity meter connection terminal block (1) comprising an insulating-material housing (9), comprising conductor connections (18) for the connection of electrical energy supply lines (12a, 12b) and comprising electricity meter connection terminals (21) for the electrically conductive connection of conductor connections (18) to associated connection contacts (24) of an electricity meter (2) received by the electricity meter connection terminal block (1), **characterized in that** the electricity meter connection terminals (21)are formed as fork contacts having two fork tines (23) connected to one another by means of a common tongue root (35) and suitable for contact-connection of an associated blade contact (24) of an electricity meter (2), said blade contact being able to be received between the fork tines (23), and **in that** the insulating-material housing (9) has connection contact receiving openings (42) for receiving a respectively associated connection contact (24) of an electricity meter (2), wherein the connection contact receiving openings (42) define an insertion direction (E) of the connection contacts (24) into the insulating-material housing (9) of the electricity meter connection terminal block (1) and **in that** the energy meter connection terminals (21) embodied as fork contacts extend transversely to the insertion direction (E) of associated blade contacts (24), which can be inserted into a respective connection contact receiving opening (42) .

2. Electricity meter connection terminal block (1) according to Claim 1, **characterized in that** the fork contacts (21) are integrally formed with a busbar (20) for an associated conductor connection (18).

3. Electricity meter connection terminal block (1) according to Claim 2, **characterized in that** the busbar (20), in the region of the fork contact (21), is bent away from a busbar plane opposite to the direction of extension of the free ends of the fork tines (23) and transition by means of a deflection section (22) into the section of the fork tines (23) that forms a contact slot (32) for a blade contact (24).

4. Electricity meter connection terminal block (1) according to one of Claims 1 to 3, **characterized in that** the conductor connections (18) are embodied as spring-force clamping connections.

5. Electricity meter connection terminal block (1) according to one of the preceding claims, **characterized in that** a spring slot (34), which is narrower in comparison to the contact slot (32), is attached to a contact slot (32) formed by the fork tines (23) spaced apart from one another and serving to receive a blade contact (24).

6. Electricity meter connection terminal block (1) according to one of the preceding claims, **characterized in that** at least one locking element (28) for locking the electricity meter connection terminal block (1) is provided with an inserted connection contact (24) of an electricity meter (2).

7. Electricity meter connection terminal block (1) according to one of the preceding claims, **characterized in that** the insulating-material housing (9) has bridge openings (11), which are open towards the free ends of the fork tines (23) of the fork contacts (21) and serve to receive bridge-blade contacts (26) of a bridging element (27) that can be received by the electricity meter connection terminal block (1).

8. Electricity meter connection terminal block (1) according to either of Claims 6 and 7, **characterized in that** the locking element (28) is a spring-loaded lock for inserting into a latching recess (30) of an inserted connection contact (24) of an electricity meter (2).

9. Electricity meter connection terminal block (1) according to one of the preceding claims, **characterized in that** at least one locking element (28) is arranged in the insulating-material housing (9) adjacent to an associated electricity meter connection terminal (21), wherein the locking element (28) is spring-loaded and can be displaced from an open position under spring force to a locking position and, in the locking position, is provided for insertion into a latching recess (30) of an inserted connection contact (24) of an energy meter (2).

10. Electricity meter (2) comprising an electricity meter connection terminal block (1) according to one of the preceding claims, **characterized in that** the electricity meter (2) has blade contacts (24) comprising a flat contact blade for contact-connecting an associated fork contact (21) of the electricity meter connection terminal block (1), wherein at least one of the blade contacts (24) has a latching recess (30), which is designed for latching with a locking element (28) of an electricity meter connection terminal block (1).

## Revendications

1. Bloc de bornes de connexion de compteur électrique (1), avec un boîtier en matériau isolant (9), avec des connexions conductrices (18) destinées à la connexion de lignes d'alimentation en énergie (12a, 12b) électriques et avec des bornes de connexion de compteur électrique (21) destinées au raccordement électriquement conducteur de connexions conductrices (18) à des contacts de connexion (24) associés d'un compteur électrique (2) reçu par le bloc de bornes de connexion de compteur électrique (1), **caractérisé en ce que** les bornes de connexion de compteur électrique (21)sont formés en tant que contacts à fourche avec deux dents de fourche (23) raccordées l'une à l'autre par le biais d'une racine de languette (35) commune et appropriées pour une mise en contact d'un contact à couteau (24) d'un compteur électrique (2) associé pouvant être reçu entre les dents de fourche (23), et **en ce que** le boîtier en matériau isolant (9) a des ouvertures de réception de contacts de connexion (42) destinées à recevoir respectivement un contact de connexion (24) associé d'un compteur électrique (2), les ouvertures de réception de contacts de connexion (42) définissant une direction d'introduction (E) des contacts de connexion (24) dans le boîtier en matériau isolant (9) du bloc de bornes de connexion de compteur électrique (1), et **en ce que** les bornes de connexion de compteur électrique (21) réalisées en tant que contacts à fourche s'étendent transversalement à la direction d'introduction (E) de contacts à couteau (24) associés qui peuvent être introduits dans une ouverture de réception de contacts de connexion (42) respective.

2. Bloc de bornes de connexion de compteur électrique (1) selon la revendication 1, **caractérisé en ce que** les contacts à fourche (21) sont formés d'un seul tenant avec une barre omnibus (20) pour une connexion conductrice (18) associé.

3. Bloc de bornes de connexion de compteur électrique (1) selon la revendication 2, **caractérisé en ce que**, dans la zone du contact à fourche (21), la barre omnibus (20) est courbe en s'éloignant d'un plan de rail omnibus à l'opposé de la direction d'étendue des extrémités libres des dents de fourche (23) et se transforment, par le biais d'un tronçon de déviation (22), en tronçon des dents de fourche (23) formant une fente de contact (32) pour un contact à couteau (24).

4. Bloc de bornes de connexion de compteur électrique (1) selon l'une des revendications 1 à 3, **caractérisé en ce que** les connexions conductrices (18) sont réalisées en tant que connexions à bornes à ressort.

5. Bloc de bornes de connexion de compteur électrique (1) selon l'une des revendications précédentes, **caractérisé en ce qu'**une fente à ressort (34), plus étroite comparée à la fente de contact (32), est contiguë à une fente de contact (32) formée par les dents de fourche (23) espacées les unes des autres pour la réception d'un contact à couteau (24).

6. Bloc de bornes de connexion de compteur électrique (1) selon l'une des revendications précédentes, **caractérisé en ce qu'**il est prévu au moins un élément de verrouillage (28) destiné au verrouillage du bloc de bornes de connexion de compteur électrique (1) avec un contact de connexion (24) introduit d'un compteur électrique (2).

7. Bloc de bornes de connexion de compteur électrique (1) selon l'une des revendications précédentes, **caractérisé en ce que** le boîtier en matériau isolant (9) a des ouvertures pour éléments de pontage (11) qui sont ouvertes vers les extrémités libres des dents de fourche (23) des contacts à fourche (21) et qui sont destinées à la réception de contacts à couteau d'éléments de pontage (26) d'un élément de shuntage (27) pouvant être reçu par le bloc de bornes de connexion de compteur électrique (1).

8. Bloc de bornes de connexion de compteur électrique (1) selon l'une des revendications 6 ou 7, **caractérisé en ce que** l'élément de verrouillage (28) est un pêne chargé par ressort destiné à plonger dans un creux d'encliquetage (30) d'un contact de connexion (24) introduit d'un compteur électrique (2).

9. Bloc de bornes de connexion de compteur électrique (1) selon l'une des revendications précédentes, **caractérisé en ce qu'**au moins un élément de verrouillage (28) est disposé dans le boîtier en matériau isolant (9) au voisinage d'une borne de connexion de compteur électrique (21) associée, l'élément de verrouillage (28) étant chargé par ressort et pouvant être déplacé par force de ressort à partir d'une position ouverte vers une position de verrouillage et étant prévu pour, dans la position de verrouillage, plonger dans un creux d'encliquetage (30) d'un contact de connexion (24) introduit d'un compteur électrique (2).

10. Compteur électrique (2) avec un bloc de bornes de connexion de compteur électrique (1) selon l'une des revendications précédentes, **caractérisé en ce que** le compteur électrique (2) a des contacts à couteau (24) avec une lame de couteau plate pour la mise en contact d'un contact à fourche (21) associé du bloc de bornes de connexion de compteur électrique (1), au moins un des contacts à couteau (24) ayant un creux d'encliquetage (30) qui est constitué pour l'encliquetage avec un élément de verrouillage (28) d'un bloc de bornes de connexion de compteur électrique (1).
